# EUROPÄISCHE PATENTSCHRIFT

(11) **EP 1 046 992 B1**
(45) Veröffentlichungstag und Bekanntmachung des Hinweises auf die Patenterteilung: **23.06.2004**
(21) Anmeldenummer: 00107261.0
(22) Anmeldetag: 03.04.2000
(51) Int. Cl.: G06F 11/20

(54) **Halbleiterspeicher vom wahlfreien Zugriffstyp mit in zwei Ebenen organisiertem Bussystem**
Semiconductor RAM with two level bus system
Dispositif de mémoire semiconductrice à accès aléatoire avec un système de bus à deux niveaux

(30) Priorität: 19.04.1999 DE 19917589
(43) Veröffentlichungstag der Anmeldung: 25.10.2000
(73) Patentinhaber: Infineon Technologies AG, 81669 München (DE)
(72) Erfinder: Brox, Martin, Dr., 81825 München (DE); Pfefferl, Karl-Peter, 85635 Höhenkirchen-Siegertsbrunn (DE)
(74) Vertreter: Epping, Hermann, Fischer

(56) Entgegenhaltungen:
- US-A- 5 666 480
- US-A- 5 761 138
- US-A- 5 781 717
- US-A- 5 843 799

## Beschreibung

Die Erfindung bezieht sich auf einen Halbleiterspeicher vom wahlfreien Zugriffstyp mit Datenleitungen, die mit den im Speicherzellenfeld befindlichen lokalen Datenleitungen verbindbar sind, wobei die Datenleitungen in Gruppen zusammengefasst sind und mindestens eine Gruppe oder einzelne Datenleitungen der Gruppen durch Redundanzdatenleitungen ausgebildet sind, sowie mit aus dem Speicher in Gruppen heraus führenden Ein/Ausgabeleitungen ("IO = Input / Output").

Bei einer typischen Architektur eines 64-MBit-DRAMs ist die Speicherfläche in vier Quadranten zu 32 Bit Datenbreite des insgesamt 128 Bit umfassenden Speichers aufgeteilt. Die 32-Bit-breiten Datenbusse der Quadranten werden weiter in vier Gruppen zu 8 Bit unterteilt. Die Datenleitungen der Datenbusse sind mit aus dem Speicher heraus fuhrenden Ein/Ausgabeleitungen ("IO = Input / Output") verbindbar ausgestaltet.

Bisherige Konzepte bei DRAMs verfügen über wenigstens eine redundante Darenleitung pro Gruppe oder eine komplette redundante Gruppe. Eine Gruppe umfasst hierbei eine Anzahl von Datenleitungen.

Bei diesem Konzept der Redundanz innerhalb einer Gruppe ist keine Verbindung der Gruppen untereinander vorgesehen. Nachteilig bei diesem Ansatz ist, das die maximal mögliche Anzahl der zu ersetzenden Datenleitungen innerhalb der Gruppe der Anzahl an redundanten Leitungen pro Gruppe entspricht.

Bei modernen Halbleiterspeichern, bei denen die voranschreitenden Technologie zu immer kleineren Strukturen führt, stellen Verunreinigungen oder andere Störparameter wie beispielsweise Schichtdickenschwankungen im Herstellungsprozess eine Ursache für Fehler dar, die sich über mehrere Datenleitungen oder Speicherzellen erstrecken.

So kann ein flachiger Fehler, ein sogenannter Cluster-Fehler, der sich über mehrere Bitleitungen oder Speicherzellen erstreckt, die speicherchipinternen Redundanzeinrichtungen bisheriger Bauart schnell an ihre Grenzen stoßen lassen. Bei einem Cluster-Fehler können in einer Gruppe mehr Datenleitungen betroffen sein, als redundante Leitungen in der Gruppe zur Verfügung stehen. In so einem Fall ist der gesamte Speicherchip nicht mehr zu verwenden und es kommt zum Totalausfall.

Auch sind Fehler und insbesondere auch Cluster-Fehler der speicherinternen lokalen Datenleitungen oder der Datenleitungen selbst bei der Herstellung nicht ausgeschlossen, wodurch ganze Gruppen von lokalen Datenleitungen, die der fehlerhaften Datenleitung zugeordnet sind, ausfallen und ersetzt werden müssen. In einem solchen Fall versagt das System der auf eine Gruppe begrenzten Redundanzdatenleitungen vollkommen.

Aus dem Dokument US-A-5,761,138 ist eine mit redundanten Speicherzellen ausgestaltene Speicheranordnung bekannt, die mehrere Ausgabeeinheiten aufweist, bei der Daten aus den jeweilligen Speicherzellenblöcken über globale I/O-Datenleitungen zu Datenausgabeleitungen der Speicheranordnung transferiert werden.

Aufgabe der Erfindung ist es, einen Halbleiterspeicher zur Verfügung zu stellen, bei dem eine flexible Zuordnung der Redundanzdatenleitungen zu verschiedenen Gruppen ermöglicht ist, bei der auch Redundanzdatenleitungen von verschiedenen Gruppen einer oder mehreren Gruppen zugeordnet werden können.

Die Lösung dieser Aufgabe erfolgt mit den kennzeichnenden Merkmalen des Anspruchs 1.

Erfindungsgemäß ist vorgesehen, dass ein in zwei Ebenen organisiertes Bussystem vorhanden ist, wobei die erste Ebene über Busleitungen verfügt, die zum einen mit allen Ein/Ausgabeleitungen und zum anderen mit allen Datenleitungen verbindbar sind, und die zweite Ebene mehrere einzelne Teil-Busse aufweist, deren Busleitungen zum einen mit jeweils allen Datenleitungen mindestens zweier Gruppen von Datenleitungen und zum anderen mit allen Ein/Ausgabeleitungen jeweils einer Gruppe verbindbar sind.

Die Erfindung schlägt also vor, über die erste und zweite Ebene des Bussystems alle Datenleitungen des Speichers mit allen Ein/Ausgabeleitungen des Speichers zu verbinden bzw. verbindbar zu halten. Vorteil hierbei ist, dass Redundanzdatenleitungen, die durch andere Datenleitungen des Speichers ausgebildet sein können, von mehreren auseinander liegenden Gruppen einer Gruppe zugeordnet werden können, um fehlerhafte Datenleitungen zu ersetzen. Die hierbei erreichte Flexibilität ist nur noch durch die Gesamtanzahl der redundanten Datenleitungen beschränkt.

In einer besonders bevorzugten Ausgestaltung der Erfindung ist vorgesehen, dass die Verbindung der Busleitungen der ersten oder der zweiten Ebene des Bussystems mit den Datenleitungen und den Ein/Ausgabeleitungen über Schalter erfolgt. Der Vorteil hierbei ist, dass die Verbindung einer Datenleitung mit einer Ein/Ausgabeleitung im Bedarfsfall durch einen Schalter reversibel geschaltet werden kann.

In einer weiterhin bevorzugten Ausgestaltung der Erfindung sind die Schalter durch eine Dreizustandsbufferschaltung ("Tristate-Buffer") ausgebildet. Der Vorteil einer Dreizustandsbufferschaltung liegt darin, dass die Verbindung reversibel geschaltet werden kann und, dass bei einer nicht benötigten Verbindung (offen) kaum Leckströme oder kapazitive Belastungen auftreten.

Gemäß einer bevorzugten Ausführung der Erfindung ist vorgesehen, dass die Schalter über vorbestimmte Zustandswerte betätigt werden.

Vorteilhafterweise werden die Zustandswerte zum Betätigen der Schalter in einem im Halbleicerspeicher integrierten Festwertspeicher gehalten. Dem folgend ist der Festwertspeicher durch eine Programmierungseinrichtung mit irreversibel einstellbaren Elementen ("Fuses" bzw. "Antifuses") ausgebildet.

In einer weiteren besonders bevorzugten Ausgestaltung der Erfindung sind die Zustandswerte für die Betätigung der Schalter nach der Durchführung eines Funktions- und Redundanz-Tests des Halbleiterspeichers gewonnen.

Weitere Vorteile, Besonderheiten und zweckmäßige Weiterbildungen der Erfindung ergeben sich aus den weiteren Unteransprüchen.

Nachfolgend wird die Erfindung anhand der Zeichnung weiter erläutert. Im Einzelnen zeigen die schematischen Darstellungen in:
- Figur 1: eine schematische Darstellung eines erfindungsgemäßen Halbleiterspeichers mit in zwei ebenen organisiertem Bussystem;
- Figur 2: eine Vergrößerung des Ausschnitts II aus Figur 1; und
- Figur 3: eine Vergrößerung des Ausschnitts III aus Figur 2.

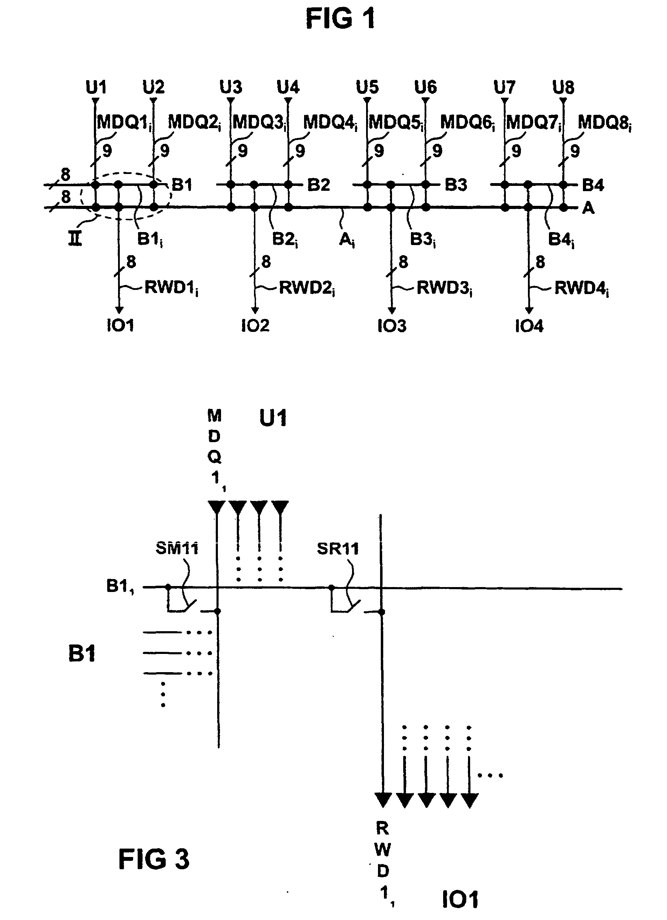

In den Figuren 1 bis 3 sind nur die zum Verständnis der Erfindung wesentlichen Bestandteile eines Halbleiterspeichers schematisch dargestellt; die einzelnen Speicherzellen und deren Anordnung sowie die Weiteren zur Ansteuerung der Speicherzellen dienenden Schaltungsbestandteile (Dekoder, Verstärker, Steuerungseinrichtungen) sind dem Fachmann geläufig, und werden daher aus Gründen der einfacheren Darstellung weggelassen.

In Figur 1 ist schematisch ein erfindungsgemäßer Halbleiterspeicher 1 dargestellt, mit den jeweils acht in Gruppen U1 bis U8 zusammengefassten Datenleitungen MDQiᵢ, über das in zwei Ebenen organisierte Bussystem mit den jeweils acht in Gruppen IO1 bis IO4 zusammengefassten IO-Leitungen RWDiᵢ verbunden werden können. Hierbei setzt sich das Bussystem in der ersten Ebene A aus acht Busleitungen A₁ bis A₈ zusammen, die mit allen vierundsechzig Datenleitungen MDQ1₁ bis MDQ8₈ aller Gruppen U1 bis U8, acht Redundanzdatenleitungen MDQ1₈ bis MDQ8₈ - diese sind in dem hier gezeigten Schaltungsbeispiel in Form von acht zusätzlichen Datenleitungen ausgebildet - und den zweiunddreißig IO-Leitungen RWD1₁ bis RWD4₈ aller Gruppen IO1 bis IO4 verbindbar sind und in der zweiten Ebene aus Teil-Bussen B1 bis B4, deren acht Busleitungen Bi₁ bis Bi₈ mit jeweils zwei Gruppen von jeweils acht Datenleitungen MDQi₁ bis MDQi₈ sowie deren Redundanzdatenleitung MDQi₈ und jeweils einer Gruppe von acht IO-Leitungen RWDi₁ bis RWDi₈ verbindbar sind. Bei einem Datenzugriff auf die (in den Figuren nicht näher dargestellten) Speicherzellen werden entweder die geradzahligen (U2, U4, U6, U8) oder die ungeradzahligen (U1, U3, U5, U7) Gruppen von Datenleitungen mit den Gruppen IO1 bis IO4 der IO-Leizungen verbunden.

Ein Teil der Datenleitungen MDQiᵢ einer Gruppe Ui sind durch bei "fehlerfrei", d.h. ohne defekte Speicherzellen oder Datenleitungen, hergestelltem Speicher redundante Datenleitungen MDQi_{R}, sogenannte Redundanzdatenleitungen ausgebildet (im vorliegenden Beispiel jeweils eine der Datenleitungen einer Gruppe U₁). Werden diese nicht benötigt, so werden sie nicht über das in zwei Ebenen A und B ausgebildete Bussystem mit den aus dem Speicher heraus führenden IO-Leitungen RWDiᵢ verbunden. Sollten aber einzelne Datenleitungen der Datenleitungen MDQ1₁ bis MDQ8₈ fehlerhaft sein, so werden diese nicht vermittels des Bussystems mit den IO-Leitungen verbunden, sondern eine entsprechende Anzahl von Redundanzdatenleitungen der Redundanzdatenleitungen MDQ1₈ bis MDQ8_{R}. Eine Fehlerhaftigkeit von Datenleitungen kann durch fehlerhafte ihnen über die lokalen im Speicherzellenfeld befindlichen lokalen Datenleitungen zugeordnete Speicherzellen oder -bereiche sowie durch Störungen der Datenleitung oder der lokalen Datenleitungen selbst begründet sein.

Es ist auch möglich mit Hilfe der Bitleitungen oder der lokalen Bitleitungen fehlerhafte Speicherzellen durch redundante Speicherzellen durch geeignete Verschaltung zu ersetzen. In diesem Fall kann auf eine zusätzliche redundante Datenleitung MDQi_{R} verzichtet werden. Zur Aufschaltung der die Daten der redundanten Speicherzellen tragenden Datenleitung kann das Bussystem in der selben Art und Weise betrieben werden, als wenn eine zusätzliche Datenleitung hierzu vorhanden wäre.

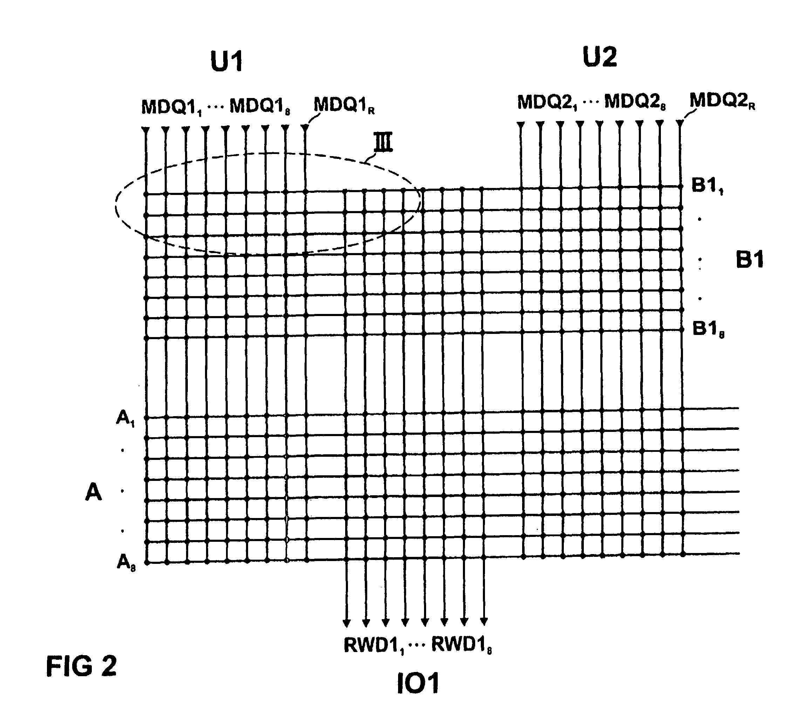

Figur 2 zeigt eine Vergrößerung des in Figur 1 mit II bezeichneten Abschnitts. Dargestellt sind die Datenleitungen MDQ1₁ bis MDQ1₈ der ersten Gruppe U1, eine Redundanzdatenleitung MDQ1_{R}, sowie die Datenleitungen MDQ2₁ bis MDQ2₈ und MDQ2_{R} der zweiten Gruppe U2, die Busleitungen B1₁ bis B1₈ des ersten Teil-Busses B1, die IO-Leitungen RWD1₁ bis RWD1₈ der ersten Gruppe IO1 von IO-Leitungen, sowie die Busleitungen A₁ bis A₈ des Busses der ersten Ebene A, wobei letztere mit allen anderen Daten-, Redundanzdaten- und IO-Leitungen verbunden sind.

Exemplarisch sind in der Figur 3, die eine Vergrößerung des in Figur 2 mit III bezeichneten Abschnitts ist, die Schalter SM11 und SR11 für die Verbindung der ersten Busleitung B1₁ des ersten Teil-Busses B1 mit der ersten Datenleitung MDQ1₁ der ersten Gruppe U1 von Datenleitungen und mit der ersten IO-Leitung RWD1₁ der ersten Gruppe IO1 von IO-Leitungen dargestellt. Die Schalter SRii und SMii können hierbei erfindungsgemäß durch sogenannte "Fuses" oder "Antifuses" ausgebildet sein, die bei erstmaliger Initialisierung des Speichers beim Testen desselben fest (irreversibel) eingestellt werden. Ebenso können die Schalter SRii und SMii innerhalb einer Dreizustandsbufferschaltung ausgebildet sein.

Eine Dreizustandsbufferschaltung hat den Vorteil, dass vermittels dieser die Schalter nicht irreversibel geschlossen werden, was bei Deaktivierung (Öffnen) der Schalter zu sehr hochohmigen und niederkapazitiven Kontakten und somit zu kleinen Belastungen führt. Auch kann die Dreizustandsbufferschaltung für die Aufschaltung der geradzahligen oder ungeradzahligen Gruppen von Datenleitungen auf die IO-Leitungen beim Datenzugriff dienen, was den Raum einer weiteren Schaltung hierfür einsparen würde. Die Betätigung der einzelnen Schalter der Redundanzdatenleitungen und der defekten Datenleitungen innerhalb der Dreizustandsbufferschaltung kann wiederum durch "Fuses" oder "Antifuses" oder dergleichen programmierbare Festwertspeicher erfolgen, deren Programmierung nach den Ergebnissen des Speichertests erfolgt. Hierbei werden zweckmäßiger Weise auch soweit es geht defekte Datenleitungen durch Redundanzdatenleitungen durch Aufschalten der kurzen Busleitungen Bi. der zweiten Ebene B Bussystems anstelle der langen Busleitungen Aᵢ der ersten Ebene A ersetzt, was die erforderliche Treiberleistung minimiert.

Durch das so sehr flexible Zuordnungssystem von kurzen Teil-Busleitungen Biᵢ der Teil-Busse B1 bis B4 und relativ wenigen langen Busleitungen A1 bis A8 der ersten Ebene A des Bussystems können sogar größere durch Cluster-Fehler bedingte Ausfälle mehrerer Datenleitungen einer Gruppe ausgeglichen werden. Hierbei wird in den meisten Fällen eine Verbindung über die kurzen Teil-Bus-Leitungen ausreichen, was die kapazitive Belastung der Leitungstreiber klein hält und damit auch die Laufzeiten kurz hält.

## Patentansprüche

1. Halbleiterspeicher vom wahlfreien Zugriffstyp mit Datenleitungen (MDQiᵢ), die mit den im Speicherzellenfeld befindlichen lokalen Datenleitungen verbindbar sind, wobei die Datenleitungen (MDQiᵢ) in Gruppen (U1 bis U8) aus jeweils mehreren Datenleitungen zusammengefaßt sind und mindestens eine den Gruppen (U1 bis U8) oder einzelne Datenleitungen der Gruppen (U1 bis U8) durch Redundanzdatenleitungen ausgebildet sind, sowie mit aus dem Speicher heraus führenden Ein-/Ausgabeleitungen (RWDiᵢ), wobei die Ein-/Ausgabeleitungen in Gruppen (IO1 bis IO4) aus jeweils mehreren Ein/Ausgabeleitungen zusammengefaßt sind,
**dadurch gekennzeichnet,**
**dass** ein in mindestens zwei Ebenen organisiertes Bussystem vorgesehen ist, wobei eine erste Ebene über Busleitungen (Aᵢ) verfügt, wobei jede deren Busleitungen zum einen mit allen Ein/Ausgabeleitungen (RWDiᵢ) und zum anderen mit allen Datenleitungen (MDQiᵢ) verbindbar ist, und eine zweite Ebene mehrere einzelne.Teil-Busse (B1 bis B4) aufweist, wobei jede deren Busleitungen (Biᵢ) zum einen mit den Datenleitungen (MDQiᵢ) mindestens zweier Gruppen von Datenleitungen (Ui) und zum anderen mit den Ein/Ausgabeleitungen (RWDiᵢ) jeweils einer Gruppe (IOi) verbindbar ist.

2. Halbleiterspeicher nach Anspruch 1,
**dadurch gekennzeichnet,**
**dass** die Verbindung der Busleitungen der ersten (A₁ bis A₈) oder der zweiten (B1₁ bis B4₈) Ebene des Bussystems mit den Datenleitungen (MDQiᵢ) und den Ein/Ausgabeleitungen (RWDiᵢ) über Schalter (SMii und SRii) erfolgt.

3. Halbleiterspeicher nach Anspruch 2,
**dadurch gekennzeichnet,**
**dass** die Schalter (SMii und SRii) durch eine Dreizustandspufferschaltung, d.h. eine Tristate-Buffer, ausgebildet ist.

4. Halbleiterspeicher nach Anspruch 2,
**dadurch gekennzeichnet,**
**dass** die Schalter (SMii und SRii) durch irreversibel einstellbare Elemente, d.h. Fuses bzw. Antifuses, ausgebildet sind.

5. Halbleiterspeicher nach einem der Ansprüche 2 bis 4,
**dadurch gekennzeichnet,**
**dass** die Schalter (SMii und SRii) über vorbestimmte Zustandswerte betätigt werden.

6. Halbleiterspeicher nach Anspruch 5,
**dadurch gekennzeichnet,**
**dass** die Zustandswerte zum Betätigen der Schalter (SMii und SRii) in einem im Halbleiterspeicher integrierten Festwertspeicher gehalten sind.

7. Halbleiterspeicher nach Anspruch 6,
**dadurch gekennzeichnet,**
**dass** der Festwertspeicher durch eine Programmierungseinrichtung mit irreversibel einstellbaren Elementen, d.h. Fuses bzw. Antifuses, ausgebildet ist.

8. Halbleiterspeicher nach einem der Ansprüche 5 bis 7,
**dadurch gekennzeichnet,**
**dass** die Zustandswerte für die Betätigung der Schalter (SMii und SRii) nach der Durchführung eines Funktions- und Redundanz-Tests des Halbleiterspeichers gewonnen sind.

## Claims

1. Semiconductor memory of the random access type having data lines (MDQiᵢ), which can be connected to the local data lines situated in the memory cell array, the data lines (MDQiᵢ) being combined in groups (U1 to U8) of a plurality of data lines in each case and at least one of the groups (U1 to U8) or individual data lines of the groups (U1 to U8) being formed by redundancy data lines, and having input/output lines (RWDiᵢ) leading from the memory, the input/output lines being combined in groups (IO1 to IO4) of a plurality of input/output lines in each case,
**characterized**
**in that** a bus system organized in at least two planes is provided, a first plane being provided with bus lines (Aᵢ), each of whose bus lines can be connected to all of the input/output lines (RWDiᵢ), on the one hand, and to all of the data lines (MDQiᵢ), on the other hand, and a second plane having a plurality of individual partial buses (B1 to B4), each of whose bus lines (Biᵢ) can be connected to the data lines (MDQiᵢ) of at least two groups of data lines (Ui), on the one hand, and to the input/output lines (RWDiᵢ) of in each case one group (IOi), on the other hand.

2. Semiconductor memory according to Claim 1,
**characterized**
**in that** the bus lines of the first (A₁ to A₈) or of the second (B1₁ to B4₈) plane of the bus system are connected to the data lines (MDQiᵢ) and to the input/output lines (RWDiᵢ) via switches (SMii and SRii).

3. Semiconductor memory according to Claim 2,
**characterized**
**in that** the switches (SMii and SRii) is [sic] formed by a tristate buffer circuit, i.e. a tristate buffer.

4. Semiconductor memory according to Claim 2,
**characterized**
**in that** the switches (SMii and SRii) are formed by elements, i.e. fuses and antifuses, that can be set irreversibly.

5. Semiconductor memory according to one of Claims 2 to 4,
**characterized**
**in that** the switches (SMii and SRii) are actuated by means of predetermined state values.

6. Semiconductor memory according to Claim 5,
**characterized**
**in that** the state values for actuating the switches (SMii and SRii) are held in a read-only memory integrated in the semiconductor memory.

7. Semiconductor memory according to Claim 6,
**characterized**
**in that** the read-only memory is formed by a programming device with elements, i.e. fuses and antifuses, that can be set irreversibly.

8. Semiconductor memory according to one of Claims 5 to 7,
**characterized**
**in that** the state values for actuating the switches (SMii and SRii) are obtained after a function and redundancy test of the semiconductor memory has been carried out.

## Revendications

1. Mémoire à semi-conducteur du type à accès aléatoire ayant des lignes (MDQIᵢ) de données, qui peuvent être reliées aux lignes de données locales se trouvant dans le champ de cellules de mémoire, les lignes (MDQIᵢ) de données étant rassemblées en groupes (U1 à U8), constitués respectivement de plusieurs lignes de données et au moins l'un des groupes (U1 à U8) ou des lignes individuelles de données des groupes (U1 à U8) sont constitués de lignes redondantes de données, ainsi que des lignes (RWDIᵢ) d'entrée/sortie sortant de la mémoire, les lignes d'entrée/sortie étant rassemblées en groupes (IO1 à IO4) constitués de plusieurs lignes d'entrée/données respectivement,
**caractérisée**
**en ce qu'**il est prévu un système de bus organisé en au moins deux plans, un premier plan disposant de lignes (Aᵢ) de bus, chacune de ses lignes de bus pouvant être reliée d'une part à toutes les lignes (RWDIᵢ) d'entrée/sortie et d'autre part à toutes les lignes (MDQIᵢ) de données, et un deuxième plan ayant plusieurs sous-bus (B1 à B4), chacune de ses lignes (Biᵢ) de bus pouvant être reliée d'une part aux lignes (MDQIᵢ) de données d'au moins deux groupes de lignes (Ui) de données et d'autre part aux lignes (RWDIᵢ) d'entrée/sortie de respectivement un groupe (IOi).

2. Mémoire à semi-conducteur suivant la revendication 1, **caractérisée en ce que** la liaison des lignes de bus du premier (A₁ à A₈) ou du deuxième (B1₁ à B4₄) plan du système de bus, avec les lignes (MDQIᵢ) de données et les lignes (RWDIᵢ) d'entrée/sortie, s'effectue par des interrupteurs (SMii et SRii).

3. Mémoire à semi-conducteur suivant la revendication 2, **caractérisée en ce que** l'interrupteur (SMii et SRii) est constitué par un circuit tampon à trois états, c'est-à-dire un tampon tristate.

4. Mémoire à semi-conducteur suivant la revendication 2, **caractérisée en ce que** les interrupteurs (SMii et SRii) sont constitués par des éléments réglables de manière irréversible (c'est-à-dire par des fusibles ou des anti-fusibles).

5. Mémoire à semi-conducteur suivant l'une des revendications 2 à 4, **caractérisée en ce que** les interrupteurs (SMii et SRii) sont actionnés par des valeurs d'état déterminées à l'avance.

6. Mémoire à semi-conducteur suivant la revendication 5, **caractérisée en ce que** les valeurs d'état pour actionner les interrupteurs (SMii et SRii) sont conservées dans une mémoire de valeur constante.

7. Mémoire à semi-conducteur suivant la revendication 6, **caractérisée en ce que** la mémoire de valeur constante est constituée par un dispositif de programmation ayant des éléments réglables d'une manière irréversible, c'est-à-dire des fusibles et des anti-fusibles.

8. Mémoire à semi-conducteur suivant l'une des revendications 5 à 7, **caractérisée en ce que** les valeurs d'état pour le fonctionnement des interrupteurs (SMii et SRii) sont obtenus en effectuant un test de fonctionnement et de redondance de la mémoire à semi-conducteur.
